# EUROPEAN PATENT APPLICATION

(11) **EP 2 302 724 A1**
(43) Date of publication of application: **30.03.2011**
(21) Application number: 08791268.9
(22) Date of filing: 17.07.2008
(51) Int. Cl.: H01M 10/42, H01M 10/48

(54) **STORAGE BATTERY SYSTEM, STORAGE BATTERY MONITORING DEVICE, AND STORAGE BATTERY MONITORING METHOD**

(71) Applicant: Mitsubishi Heavy Industries, Ltd., Tokyo 108-8215 (JP)
(72) Inventor: HASHIMOTO, Tsutomu, Tokyo 108-8215 (JP); HASHIZAKI, Katsuo, Nagasaki-shi Nagasaki 850-8610 (JP); NISHIDA, Takehiko, Nagasaki-shi Nagasaki 851-0392 (JP)
(74) Representative: Bongiovanni, Simone
(86) International application number: PCT/JP2008/062914
(87) International publication number: WO 2010/007681

(57) **Abstract**

In order to identify whether each of the cells in a storage battery system is available, the storage battery system is equipped with secondary cell packs, information storage parts which are respectively installed to the secondary cell packs to store cell information on the respective secondary cell packs, and monitor device which judges whether loading to the storage battery system is possible according to the cell information stored in the information storage part.

## Description

### Technical Field

The present invention relates to a storage battery system, a storage battery monitoring device, and a storage battery monitoring method.

### Background Art

A storage battery system using a chargeable secondary cell is used as a power source for moving vehicles such as electric vehicles (EV) and electric forklifts or a stationary power source for a power storage device. In the storage battery system, a plurality of electrically-connected cell are generally used.

In charging/discharging each of the plurality of electrically-connected cell with same electric power, when the cells have different characteristics (for example, a charging capacity), some of the cells may be overcharged or overdischarged.

In this connection, Japanese patent publication JP2003-217534A (patent literature 1) describes a technique of providing a cell pack in which each of single cells is charged in an optimum state even when the cells have different initial states and cell performances to improve the life and reliability of the cells. The patent literature 1 discloses the cell pack having a plurality of chargeable single cells, a charging control circuits of the same number as the single cells and a plurality of switch circuits enabled to connect the plurality of single cells in series during discharging and enabled to individually connect each of the plurality of single cell to each of the charging control circuits during charging.

### Summary of Invention

In a storage battery system mounted on vehicles such as EV, a plurality of cells may be replaced by a user. In replacement, all of the plurality of cells may be replaced at one time or only some of the plurality of cells may be replaced.

In replacing some of the plurality of cells, when newly-mounted cells have characteristics that are identical to characteristics of remained unreplaced cells, there is no problem. However, when the new cells have characteristics that are different from the characteristics of the remained cells, some cells may be overcharged or overdischarged as described above. It is difficult for a user to identify whether or not the characteristics of the newly-mounted cells match characteristics of the other cells before the replacement.

Therefore, an object of the present invention is to provide a storage battery system, a storage battery monitoring device and a storage battery monitoring method, which can identify whether or not a cell can be mounted on the storage battery system.

A storage battery system according to the present invention includes: a plurality of secondary cell pack installed in a moving vehicle; an information storage part which is attached to each of the plurality of secondary cell pack and stores cell information concerning the each secondary cell back; and a monitoring device configured to determine whether or not the secondary cell packs can be mounted on the storage battery system or determine whether or not a combination of the plurality of secondary cell pack is appropriate, based on the cell information stored in the information storage part.

According to the present invention, since the monitoring device determines whether or not a specification of a secondary cell pack to be newly attached is appropriate, use of a wrong secondary cell pack is prevented. Since the monitoring device determines whether or not the combination of the plurality of secondary cell pack is appropriate, use of the secondary cell packs having different characteristics in combination is prevented. As a result, occurrence of the overcharged or overdischarged secondary cell pack is prevented.

The storage battery system according to the present invention includes a storage part for storing system standard information that represents a specification range of a mountable secondary cell pack. The information storage part stores specification information that represents a specification of each of the secondary cell packs as the cell information. At this time, it is preferred that the monitoring device compares specifications of the plurality of secondary cell pack with the system standard information to determine whether or not the each secondary cell pack can be mounted.

It is preferred that the specification information includes information on at least one of an appropriate voltage range (maximum charging voltage, minimum discharging voltage), an appropriate current range (maximum charging current, maximum discharging current), a capacity range, an input/output range, a temperature range and a resistance value range.

The storage battery system according to the present invention may further include a current state detection part provided in the each secondary cell pack, and the current state detection part detects a current state of the each secondary cell pack. At this time, cell information may include current information representing the current state of the each secondary cell pack. The current state detection part stores the detected current state in the information storage part as the current information. At this time, it is preferred that the monitoring device determines whether or not the secondary cell packs can be mounted by comparing the current states of the plurality of secondary cell pack with each other based on the current information.

It is preferred that the current information includes information on at least one of a current charging capacity, a current internal resistance and a number of charge/discharge cycles of the each secondary cell pack.

It is preferred that the monitoring device is connected between both ends of the whole of the plurality of secondary cell pack, and acquires the cell information from the information storage part through a closed circuit that is formed of the monitoring device and the plurality of secondary cell pack.

The storage battery system according to the present invention may further include a wireless part attached to the each secondary cell pack, and the wireless part wirelessly transmits the cell information stored in the information storage part to the monitoring device. At this time, it is preferred that the monitoring device includes a wireless receiving part configured to wirelessly receive the transmitted cell information.

A storage battery monitoring device according to the present invention includes: a cell information acquisition part configured to acquire the cell information about each of a plurality of secondary cell pack from the plurality of secondary cell pack; and a cell determination part configured to determine whether or not the secondary cell pack can be mounted based on the acquired cell information.

A secondary cell pack according to the present invention is a secondary cell pack mounted on a moving vehicle or a power storage device. The secondary cell pack includes: at least one single cell; and an information storage part storing cell information about the single cell. The cell information is transmitted to a monitoring device provided in a storage battery system when the secondary cell pack is attached to the storage battery system.

A storage battery monitoring method according to the present invention includes: acquiring cell information on each of a plurality of secondary cell pack from the plurality of secondary cell pack; and determining whether or not the secondary cell packs can be mounted by determining whether or not a combination of the plurality of secondary cell pack is appropriate based on the acquired cell information.

It is preferred that the cell information includes current information representing a current state of the each secondary cell pack, and the determining includes determining whether or not the secondary cell packs can be mounted by comparing the current states of the plurality of secondary cell pack with each other based on the current information.

According to the present invention, the storage battery system, the storage battery monitoring device and the storage battery monitoring method are provided, which can identify whether or not each of the single cells in the storage battery system is available.

### Brief Description of Drawings

Fig. 1 is a diagram schematically showing a configuration of a storage battery system according to a first embodiment.
Fig. 2A is a conceptual diagram showing cell information.
Fig. 2B is a conceptual diagram showing the cell information.
Fig. 3 is a diagram schematically showing a configuration of a battery monitoring unit.
Fig. 4 is a diagram schematically showing a configuration of a storage battery system according to a second embodiment.
Fig. 5 is a diagram schematically showing a configuration of a storage battery system according to a third embodiment.

### Description of Embodiments

### First embodiment

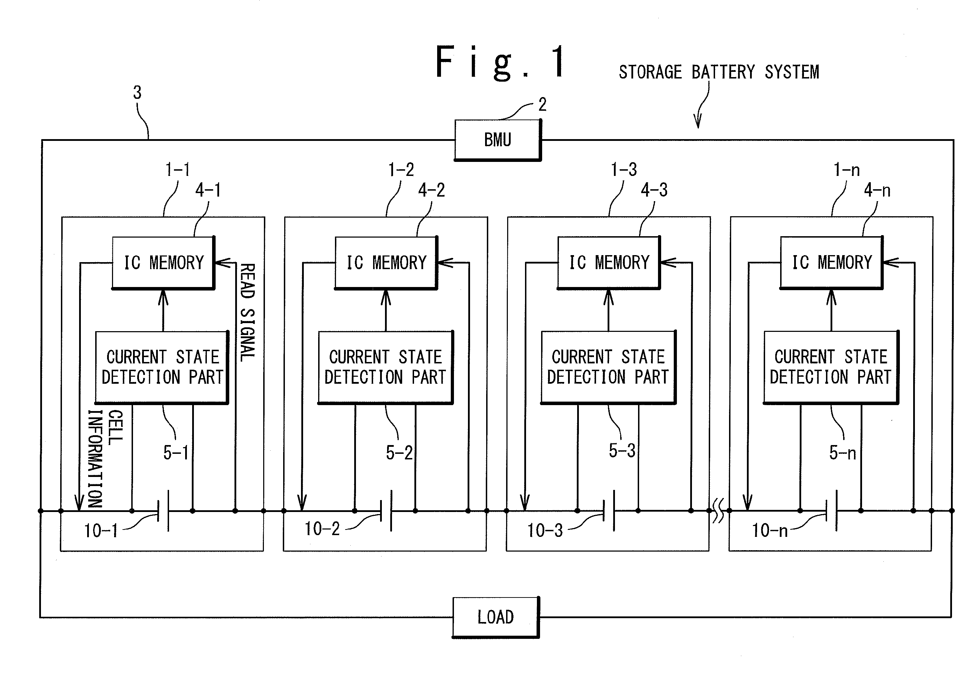

Referring to drawings, embodiments of the present invention will be described. Fig. 1 is a diagram schematically showing a storage battery system according to the present embodiment. Although not shown, it is assumed that the storage battery system is mounted on an EV, a battery fork lift or the like as a power source for driving.

As shown in Fig. 1, the storage battery system includes a plurality of secondary cell pack (1-1 to 1-n) and a battery monitoring unit 2 (hereinafter referred to as BMU). Each of the plurality of secondary cell pack (1-1 to 1-n) is removably attached to the storage battery system. While being attached to the storage battery system, the plurality of secondary cell pack (1-1 to 1-n) are electrically connected in series and connected to a load as a driving source of the EV. The BMU 2 is provided in order to monitor states of the plurality of secondary cell pack (1-1), and is connected between a positive-side terminal and a negative-side terminal of a whole of the plurality of secondary cell pack (1-1 to 1-n). In this manner, a closed circuit 3 is formed of the BMU 2 and the plurality of secondary cell pack (1-1 to 1-n).

Each of the secondary cell packs 1 has at least one chargeable/dischargeable single cell 10. For example, a lithium-ion cell is used as the single cell 10. Each secondary cell pack 1 is defined as a minimum unit that can be replaced. In the example shown in Fig. 1, one single cell 10 is included in one secondary cell pack 1. However, a plurality of single cell 10 may be included in one secondary cell pack 1. That is, a cell group included in the secondary cell pack 1 is a minimum unit formed of a plurality of cells connected to each other, and the cell group may include only one single cell.

In the each secondary cell pack, an IC memory 4 (information storage part) and a current state detection part 5 are provided.

The IC memory 4 stores cell information that is information concerning the each secondary cell pack 1. When the each secondary cell packs 1 is attached to the storage battery system, the IC memory 4 is connected to the closed circuit 3. The IC memory 4 transmits the cell information to the BMU 2 through the closed circuit 3, when receiving a read signal through the closed circuit 3.

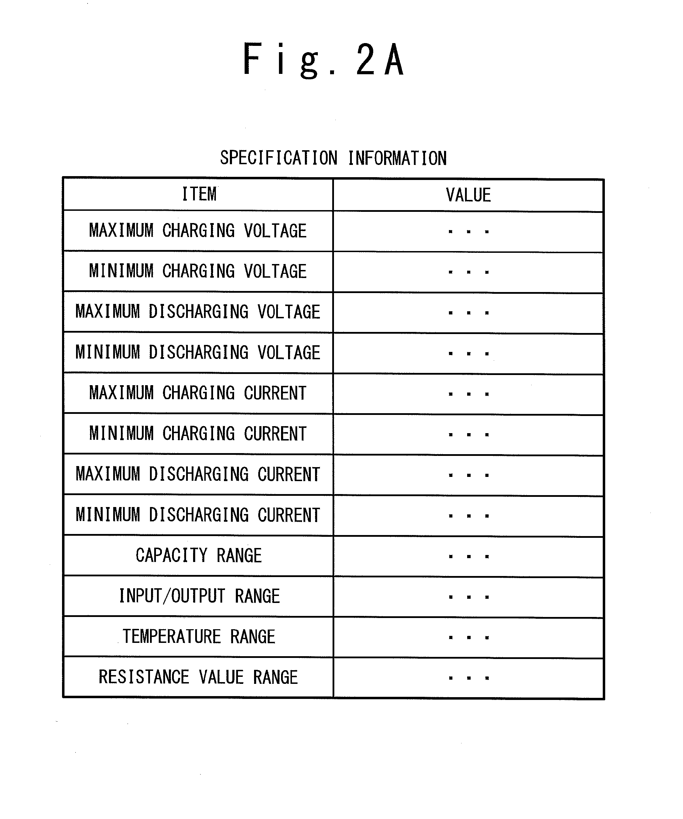

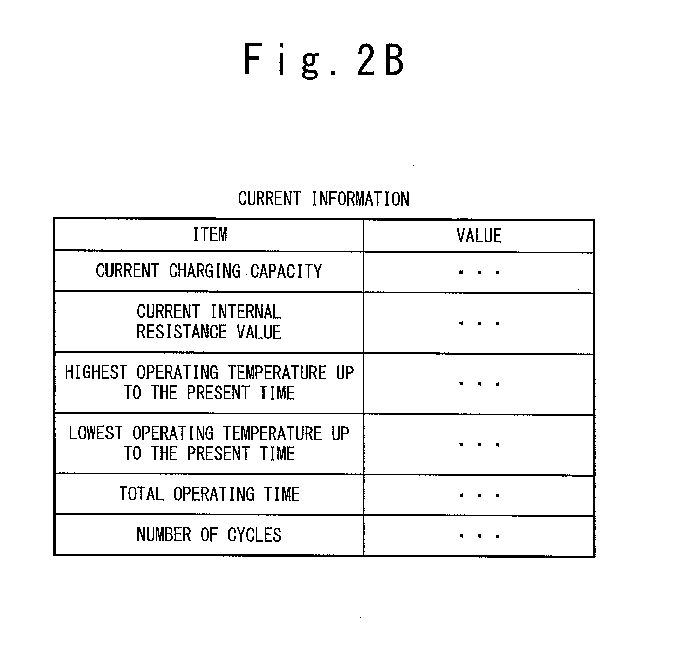

Figs. 2A and 2B are conceptual diagrams showing the cell information. The cell information includes specification information and current information. Fig. 2A shows the specification information and Fig. 2B shows the current information.

The specification information is information representing a specification of the each secondary cell pack 1. Specifically, as shown in Fig. 2A, the specification information includes information on at least one of an appropriate charging voltage range (maximum charging voltage, minimum charging voltage), an appropriate discharging voltage range (maximum discharging voltage, minimum discharging voltage), an appropriate charging current range (maximum charging current, minimum charging current), an appropriate discharging current range (maximum discharging current, minimum discharging current), a capacity range, an input/output range, a temperature range and a resistance value range. It should be noted that the input/output range is information representing an acceptable power range during inputting (during charging) and an acceptable power range during outputting (during discharging). The specification information is stored in the IC memory 4 in a nonvolatile manner at manufacturing of the each secondary cell pack 1.

The current information shown in Fig. 2B is information indicating a current state of the each secondary cell pack 1. Specifically, the current information includes information on at least one of a current charging capacity, a current internal resistance value, a highest operating temperature up to the present time, a lowest operating temperature up to the present time, a total operating time and a number of cycles. The "highest operating temperature up to the present time" represents a highest temperature during use (during charging/discharging) from manufacturing of the secondary cell pack 1 to the present time. The "lowest operating temperature up to the present time" represents a lowest temperature during use (during charging/discharging) from manufacturing of the secondary cell pack 1 to the present time. The "total operating time" represents a total time when the secondary cell pack 1 is charged and discharged. The "number of cycles" represents a number of charging/discharging times after manufacturing. The current information is written to the IC memory 4 by the current state detection part 5.

The current state detection part 5 detects a current state of the single cell 10, for example periodically, and writes the detection result to the IC memory 4 as the current information. The current state detection part 5 also counts a number of charging/discharging times of the single cell 10, and stores the counted number in the IC memory 4 as the number of cycles.

A method of detecting the current state by the current state detection part 5 is not specifically limited.

For example, the "current charging capacity" and the "current internal resistance value" can be detected by utilizing a fact that a voltage of the single cell 10 depends on a charging capacity. In this case, the current state detection part 5 may include a voltage sensor for measuring the voltage of the single cell 10, and a voltage-charging capacity storage part for previously storing a correspondence relationship between the voltage and the charging capacity. The current charging capacity can be detected by referring to the voltage-charging capacity storage part based on a voltage value of the single cell 10 that is actually measured by the voltage sensor.

Alternatively, the "current charging capacity" can be detected by summing current values. In this case, the current state detection part 5 may include an ammeter for measuring a current flowing through the single cell 10.

For example, the current internal resistance value can be detected by providing an ammeter and a voltmeter for respectively measuring a current value and a voltage value of the single cell 10.

For example, the highest operating temperature up to the present time and the lowest operating temperature up to the present time can be detected, by providing a thermometer for measuring the temperature of the single cell 10.

The total operating time can be measured by attaching a timer device having a timer function to the single cell 10.

A method of counting the number of cycles is not specifically limited, and the number of cycles may be counted, for example, based on change in the charging capacity.

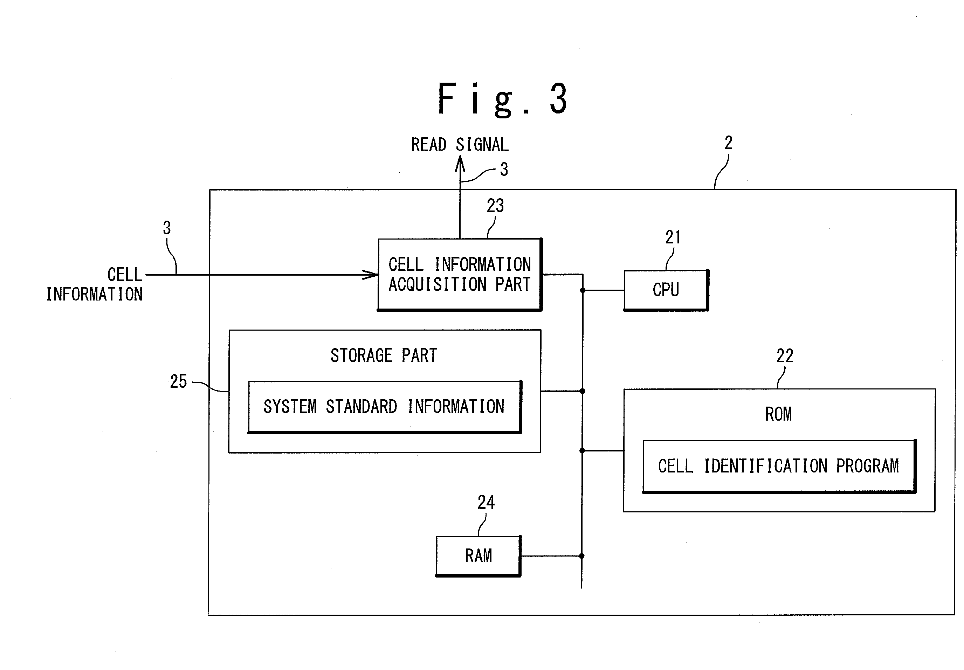

Subsequently, the BMU 2 will be described. Fig. 3 is a diagram schematically showing a functional configuration of the BMU 2. The BMU 2 is attached to monitor operations of the plurality of secondary cell pack 1 and determine whether or not the secondary cell packs can be mounted on the storage battery system. The BMU 2 determines whether or not an attached secondary cell pack can be mounted on the storage battery system by indentifying whether or not a combination of the plurality of secondary cell is appropriate. The BMU 2 includes a CPU 21, a ROM 22, a cell information acquisition part 23, a RAM 24 and a storage part 25 for storing system standard information therein. These elements are connected to each other through a bus line.

The storage part 25 is exemplified by a hard disc or the like. The system standard information stored in the storage part 25 indicates a specification range of a mountable secondary cell pack (hereinafter referred to as appropriate specification range). The appropriate specification range represents at least one of a charging voltage range, a discharging voltage range, a charging current range, a discharging current range, a capacity range, an input/output range, a temperature range and a resistance value range.

The storage part 25 only needs to be provided in the storage battery system and need not be provided in the BMU.

The cell information acquisition part 23 is connected to the closed circuit 3, and transmits the read signal to the IC memory 4 provided in the each secondary cell pack 1 via the closed circuit 3, for example, when the secondary cell pack 1 at a certain position is replaced. Then, when the cell information is transmitted from the IC memory 4 in response to the read signal, the cell information acquisition part 23 receives the cell information through the closed circuit 3 and stores the information in the RAM 24 or the like.

The ROM 22 stores a cell identification program for identifying the secondary cell pack 1 as a computer program. The each secondary cell pack 1 is identified by the CPU 21 executing the cell identification program.

The cell information acquired by the cell information acquisition part 23 is compared with the system standard information by the cell information identification program. Specifically, the specification information of the each secondary cell pack 1 (refer to Fig. 2A) is compared with the appropriate specification range in the system standard information. Then, it is determined whether or not the specification of the each secondary cell pack 1 is within an appropriate range. When the appropriate specification range specified in the system standard information includes the specification range described in the specification information of the secondary cell pack 1, it is determined that the secondary cell pack is appropriate in terms of specification. When all of the secondary cell packs 1 have the appropriate specifications, the plurality of secondary cell pack 1 attached to the storage battery system are determined to be appropriately combined. On the contrary, when the appropriate specification range specified in the system standard information is smaller than the specification range of the secondary cell pack 1, it is determined that the secondary cell pack 1 has no appropriate specification.

By the determination mentioned above, the secondary cell packs having different specifications can be prevented from being combined.

For example, in a case where the secondary cell packs 1 having different "maximum charging voltages" are included in the plurality of secondary cell pack 1, when the plurality of secondary cell pack 1 are charged on the basis of the secondary cell pack 1 having a higher "maximum charging voltage", the secondary cell pack 1 having a lower "maximum charging voltage" is overcharged.

Further, in a case where the secondary cell packs 1 having different "minimum discharging voltages" are included, when the plurality of secondary cell pack 1 are discharged on the basis of the secondary cell pack 1 having a lower "minimum discharging voltage", the secondary cell pack 1 having a higher "minimum discharging voltage" is overdischarged.

Further, in a case where the secondary cell packs 1 having different "maximum discharging current" are included, the magnitude of a current value during discharging must be conformed with the secondary cell pack 1 having a smaller "maximum discharging current". Accordingly, characteristics of the secondary cell pack 1 having a larger "maximum discharging current" cannot be sufficiently derived.

Further, in a case where the secondary cell packs 1 having different "maximum charging current" are included, the magnitude of a current value during charging must be conformed with the secondary cell pack 1 having a smaller "maximum charging current". Accordingly, characteristics of the secondary cell pack 1 having a larger "maximum charging current" cannot be sufficiently derived.

Further, in a case where the secondary cell packs 1 having different "capacity ranges" are included, when the secondary cell pack 1 having a larger "capacity range" is completely charged, the secondary cell pack 1 having a smaller "capacity range" is overcharged.

Further, in a case where the secondary cell packs 1 having different "resistance value ranges" are included, the voltages of the secondary cell packs 1 cannot be made uniform, resulting in that the secondary cell packs 1 cannot be charged such that the voltages of all of the secondary cell packs 1 have the same value.

On the other hand, according to the present embodiment, when the appropriate specification range specified in the system standard information is smaller than the specification range of the cell in any secondary cell pack 1, it is determined that the secondary cell pack is unavailable. Accordingly, even when only one cell that is out of the appropriate specification range specified in the system standard information is mounted, the system does not operate, and failure is prevented.

Even when all of the secondary cell packs 1 have the appropriate specifications, the cell information identification program compares the current information of the plurality of secondary cell pack 1 with each other. When a difference between the current states of the plurality of secondary cell pack 1 is within a predetermined range, it is determined that the combination of the plurality of secondary cell pack 1 is appropriate. On the contrary, when the difference between the current states of the plurality of secondary cell pack 1 is out the predetermined range, it is determined that the combination of the plurality of secondary cell pack 1 is inappropriate. Specifically, it is determined whether or not a difference between the plurality of secondary cell pack 1 is within a predetermined range, about at least one of the "current charging capacity", the "current internal resistance value", the "highest operating temperature up to the present time", the "lowest operating temperature up to the present time", the "actual use time" and the "number of cycles".

When determining that the combination of the plurality of secondary cell pack 1 is inappropriate, the cell information identification program activates an alarm device (not shown) such as an audio alarm or a display device to inform the user of the unavailable combination. Alternatively, the storage battery system is controlled so as not to be operated, by a blocking device (not shown).

According to the present embodiment, the BMU 2 determines whether or not the specifications of the plurality of secondary cell pack 1 are appropriate. Whereby, it is determined whether or not the attached secondary cell packs 1 can be available. Thus, it is possible to prevent the user from wrongly using the secondary cell packs having different specifications in combination.

The secondary cell may be deteriorated by repeats of charging/discharging. Even when the secondary cell packs 1 have the same specification, different deterioration states may cause different charging capacities and internal resistance values. When the secondary cell packs 1 having different charging capacities and internal resistance values are mounted, the single cell 10 may be overcharged/overdischarged during charging/discharging.

On the other hand, according to the present embodiment, the current states of the plurality of secondary cell pack 1 are compared with each other, and when the secondary cell packs having different current states are combined, it is determined as unavailable. Thus, it is prevented that the secondary cell packs 1 having different deterioration states are used in combination. As a result, overcharging/overdischarging of the secondary cell pack during charging or discharging can be prevented more reliably.

In the present embodiment, the case has been described, where the current state detection part 5 is provided in the each secondary cell pack 1. However, the current state detection part 5 is not necessarily provided in the each secondary cell packs 1, and may be provided in a main body of the storage battery system. In this case, the current state detection part 5 may be arranged so as to be able to detect the current state of the each secondary cell pack 1 when the each secondary cell pack 1 is attached to the storage battery system. By employing such a configuration, the same effects as those described in the present embodiment can be achieved.

Further, in the present embodiment, the case has been described, where the cell information is transmitted to the BMU 2 through the closed circuit 3 that is formed of the plurality of secondary cell pack 1 and the BMU 2. However, the cell information is not necessarily transmitted to the BMU 2 through the closed circuit 3.

For example, a communication line that is separate from the closed circuit 3 may be provided in the storage battery system, and the IC memory 4 may be connected to the BMU 2 with the communication line when the each secondary cell pack 1 is attached to the storage battery system. At this time, the cell information is transmitted to the BMU 2 through the communication line. By employing such a configuration, the same effects as those described in the present embodiment can be achieved.

Further, in the IC memory 4 provided in the each secondary cell pack 1, address information may be included, which represents where the each secondary cell pack 1 is attached in the storage battery system. When the address information is included, the cell information identification program can identify which secondary cell packs 1 is unavailable, based on the address information. In addition, it can be possible to inform the user which of the unavailable secondary cell pack 1 is unavailable.

As a configuration where the address information is stored in the IC memory 4, for example, a writing part for writing the address information may be provided in the main body of the storage battery system. The writing part is configured so as to write the address information to the IC memory 4 wirelessly or by wire when the each secondary cell pack 1 is attached.

### Second embodiment

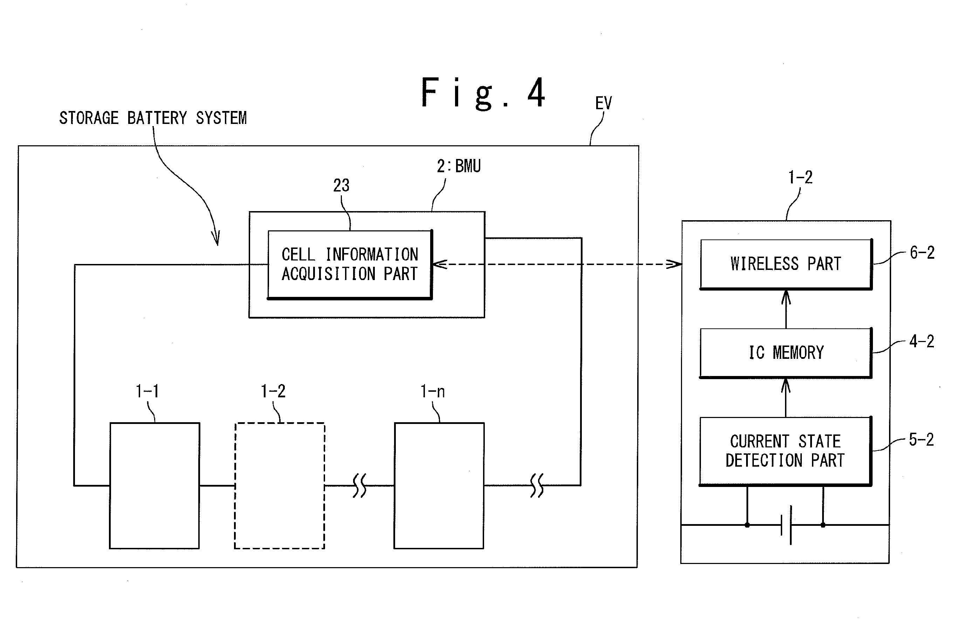

Subsequently, a second embodiment of the present invention will be described. Fig. 4 is a diagram schematically showing a configuration of a storage battery system according to the present embodiment. In the present embodiment, as compared to the first embodiment, wireless parts 6 corresponding to respective secondary cell packs 1 are added, and a function of the cell information acquisition part 23 in the BMU 2 is devised. Since other points are the same as those in the first embodiment, detailed description thereof will be omitted. In Fig. 4, in the BMU 2, illustrations other than the cell information acquisition part 23 are omitted.

As shown in Fig. 4, it is assumed that the secondary cell pack 1-2 among the plurality of secondary cell pack (1-1 to 1-n) is replaced.

Internal configurations of the secondary cell packs 1 other than the secondary cell pack 1-2 are not illustrated.

A wireless part 6-2 is provided in the secondary cell pack 1-2. The wireless part 6-2 is connected to the IC memory 4-2 and transmits the cell information stored in the IC memory 4-2 to the BMU 2 by a wireless signal. On the other hand, in the BMU 2, the cell information acquisition part 23 is configured so as to receive the cell information transmitted from the wireless part 6-2.

Since the cell information is transmitted to the BMU 2 by the wireless signal, even when the secondary cell pack 1-2 is not attached to the storage battery system, the user can identify whether or not the secondary cell pack 1-2 is available. For example, in a case of the storage battery system mounted on the EV, merely by placing the secondary cell pack 1 near the vehicle, the user can identify whether or not the secondary cell pack 1 is available.

### (Third embodiment)

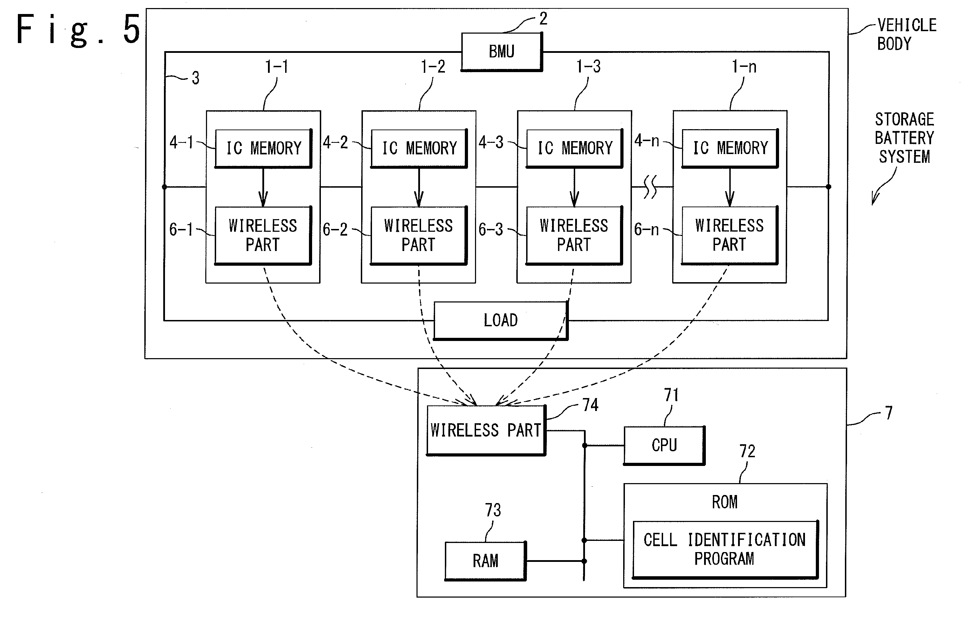

Subsequently, a third embodiment will be described. Fig. 5 is a diagram schematically showing a configuration of a storage battery system according to the present embodiment. In the present embodiment, as compared to the second embodiment, a diagnosis device 7 is added. Since other points can be same as those in the second embodiment, detailed descriptions thereof will be omitted.

As shown in Fig. 5, the diagnosis device 7 includes a wireless part 74, a CPU 71, a RAM 73 and a ROM 72. These elements are connected with each other through a bus line. The ROM 72 stores a diagnosis program therein. The diagnosis program is read and executed by the CPU 71.

The wireless part 74 wirelessly communicates with the wireless part 6 provided in the each secondary cell pack 1. The wireless part 74 receives the cell information of the each secondary cell pack 1 from the wireless part 6 by a wireless signal and stores the cell information in the RAM 73.

The diagnosis program diagnoses an optimum cell replacement time and an optimum replaced cell specification, based on the cell information acquired by the wireless part 74.

For example, the cell replacement time can be decided based on the current information included in the cell information. In a more specific example, how many times the single cell 10 provided in the each secondary cell packs 1 can be further charged and discharged is calculated, based on an upper limit of the number of cycles which is previously stored in the RAM 73 or the like, and the cell replacement time is calculated based on the calculated number of times.

For example, when a secondary cell pack 1 to be replaced is designated, the replaced cell specification can be decided based on the cell information of the remained secondary cell packs 1. For example, it is assumed that the wireless part 74 acquires a "maximum charging voltage", a "minimum charging voltage", a "maximum charging current", an "internal resistance", a "current charging capacity", a "current internal resistance value" and an "number of cycles" as the cell information, from the each secondary cell pack 1. The diagnosis program 72 calculates an average value in each of the items for the secondary cell packs 1 remained in the storage battery system, and decides the calculated average value as the replaced cell specification.

The diagnosis result of the diagnosis program is outputted by an output device not shown (for example, a display device) and informed to the user.

According to the present embodiment, the cell replacement time representing a remaining life of the each secondary cell packs 1 is informed to the user. The user can prepare a new secondary cell pack 1 by referring to the cell replacement time. Further, by informing the replaced cell specification to the user, the user can prepare the secondary cell pack 1 having an optimum specification so as to be suited for the combination of the plurality of secondary cell pack 1.

In the present embodiment, the case has been described where the diagnosis device 7 is prepared separately from the BMU 2. However, the diagnosis program may be stored in the ROM 22 in the BMU 2 so that the BMU 2 diagnoses the cell replacement time and the replaced cell specification. In this case, the BMU 2 functions as the diagnosis device 7.

## Claims

1. A storage battery system comprising:
a plurality of secondary cell pack;
an information storage part configured to be attached to each of said plurality of secondary cell pack and store cell information concerning said each secondary cell pack; and
a monitoring device configured to judge whether or not said each secondary cell pack can be mounted on said storage battery system based on said cell information.

2. The storage battery system according to claim 1, wherein said monitoring device judges whether or not a combination of said plurality of secondary cell pack is appropriate to judge whether or not mounting is possible.

3. The storage battery system according to claim 1 or 2, further comprising:
a storage part configured to store system standard information that indicates a specification range of a mountable secondary cell pack,
wherein specification information indicating specification of said each secondary cell pack is stored in said information storage part as said cell information, and
said monitoring device compares said specification information of said plurality of secondary cell pack with said system standard information to judge whether or not mounting is possible.

4. The storage battery system according to claim 3, wherein said specification information includes at least one of an available range of charging voltage, an available range of discharging voltage, an available range of charging current, an available range of discharging current, a capacity range, an input/output range, a temperature range, and a resistance value range.

5. The storage battery system according to any of claims 1 to 4, further comprising:
a current state detection part which is provided corresponding to said each secondary cell pack and detects current state of said each secondary cell pack,
wherein said cell information includes current information that indicates a current state of said each secondary cell pack,
said current state detection part stores said detected current state in said information storage part as said current information, and
said monitoring device compares current states between said plurality of secondary cell pack to judge whether or not mounting is possible.

6. The storage battery system according to claim 5, wherein said current information includes at least one of a current charging capacity of said each secondary cell pack, a current internal resistance, a highest operating temperature up to present time, a lowest operating temperature up to present time, total operating time and number of cycles.

7. The storage battery system according to any of claims 1 to 6, wherein said monitoring device is connected to both ends of whole of said plurality of secondary cell pack, and
said monitoring device obtains said cell information from said information storage part, via a closed circuit that is formed of said monitoring device and said plurality of secondary cell pack.

8. The storage battery system according to any of claims 1 to 6, further comprising:
a wireless part attached to said each secondary cell pack and wirelessly transmits said cell information stored in said information storage part to said monitoring device,
wherein said monitoring device comprises a wireless receiving part configured to receive said cell information that is wirelessly transmitted.

9. A storage battery monitoring device comprising:
a cell information acquisition part configured to acquire cell information concerning a plurality of secondary cell pack from said plurality of secondary cell pack; and
a cell identification part configured to judge whether or not mounting on a storage battery system is possible, based on said acquired cell information.

10. The storage battery monitoring device according to claim 9, wherein said cell information includes current information that indicates current state of said each secondary cell pack, and
said cell identification part compares current states of said plurality of secondary cell pack based on said current information to judge whether or not mounting is possible.

11. A secondary cell pack mounted on a moving vehicle, comprising:
at least one of single cell; and
a information storage part configured to store cell information concerning said single cell,
wherein when being attached to a storage battery system, said cell information is transmitted to a monitoring device provided in said storage battery system.

12. A storage battery monitoring method, comprising:
acquiring cell information concerning each of a plurality of secondary cell pack, from said plurality of secondary cell pack; and
judging whether or not mounting on a storage battery system is possible, based on said acquired cell information.

13. The storage battery monitoring method according to claim 12, wherein said cell information includes current information that indicates a current state of said each secondary cell pack, and
said judging comprises:
comparing current states of said plurality of secondary cell pack based on said current information to judge whether or not mounting on a storage battery system is possible.
